# EUROPEAN PATENT APPLICATION

(11) **EP 2 079 105 A1**
(43) Date of publication of application: **15.07.2009**
(21) Application number: 07859831.5
(22) Date of filing: 14.12.2007
(51) Int. Cl.: H01L 21/336, H01L 21/02, H01L 21/28, H01L 27/12, H01L 29/417, H01L 29/786

(54) **METHOD FOR MANUFACTURING SEMICONDUCTOR DEVICE, METHOD FOR MANUFACTURING DISPLAY DEVICE, SEMICONDUCTOR DEVICE, METHOD FOR MANUFACTURING SEMICONDUCTOR ELEMENT, AND SEMICONDUCTOR ELEMENT**

(30) Priority: 10.01.2007 JP 2007002821
(71) Applicant: Sharp Kabushiki Kaisha, Osaka-shi, Osaka 545-8522 (JP)
(72) Inventor: TAKEI, Michiko, Nara-shi, Nara 630-8244 (JP); TOMIYASU, Kazuhide, Tenri-shi, Nara 632-0071 (JP); FUKUSHIMA, Yasumori, Sakurai-shi, Nara 633-0062 (JP); TAKAFUJI, Yutaka, Nara-shi, Nara 631-0804 (JP); MORIGUCHI, Masao, Tenri-shi, Nara 632-0004 (JP); DROES, Steven Roy, Washington 98607 (US)
(74) Representative: Müller - Hoffmann & Partner
(86) International application number: PCT/JP2007/074157
(87) International publication number: WO 2008/084628

(57) **Abstract**

The present invention provides a production method of a semiconductor device, a production method of a display device, a semiconductor device, a production method of a semiconductor element, and a semiconductor element, each capable of providing a lower-resistance semiconductor element which is more finely prepared through more simple steps. The production method of the semiconductor device of the present invention is a production method of a semiconductor device including a semiconductor element on a substrate, wherein the production method includes a metal silicide-forming step of: transferring the semiconductor element onto the substrate, the semiconductor element having a multilayer structure of a silicon layer and a metal layer, and by heating, forming metal silicide from silicon for a metal layer-side part of the silicon layer and metal for a silicon layer-side part of the metal layer.

## Description

### TECHNICAL FIELD

The present invention relates to a production method of a semiconductor device, a production method of a display device, a semiconductor device, a production method of a semiconductor element, and a semiconductor element. More particularly, the present invention relates to a production method of a semiconductor device, a production method of a display device, a semiconductor device, a production method of a semiconductor element, and a semiconductor element, each including a step of transferring a semiconductor element onto a substrate.

### BACKGROUND ART

A semiconductor device is an electronic device that includes a semiconductor element using electronic characteristics of a semiconductor, and the like. Such a semiconductor device is now being widely used in audio equipments, communication equipments, computers, and home electric appliances, and the like. A semiconductor device including a circuit element having a MOS (metal oxide semiconductor) structure, a thin film transistor (TFT), and the like, particularly enables a liquid crystal display device and the like to provide higher-definition image display and high-speed moving picture display.

A liquid crystal display including a peripheral driving circuit such as a driving circuit and a control circuit, integrally formed with a pixel part on a substrate, what is called monolithic liquid crystal display (hereinafter, also referred to as a "system liquid crystal") is now being brought to attention. According to such a system liquid crystal, the number of components can be significantly decreased and further assembly and examination steps can be reduced. As a result, production costs can be reduced and reliability can be improved.

Such a system liquid crystal needs a reduction in power consumption, and higher-definition and higher-speed image display. Along with this need, a space for the peripheral driver circuit needs to be reduced. Specifically, sub-micron design rule, i.e., a higher pattern accuracy like one which is needed for integrated circuit (IC), needs to be adopted to the peripheral driver circuit. Also in order to improve a carrier mobility of a semiconductor layer, the semiconductor element needs to be more finely formed.

However, it is difficult to form a high-performance semiconductor element of sub-micron order directly on a glass substrate because a technology such as a stepper, in which a semiconductor element can be more finely formed on a glass substrate, has not been established yet. So, a method of preparing a semiconductor element by microfabrication, and transferring the semiconductor element chip onto a glass substrate, is used as a method of forming a high-performance semiconductor element on a glass substrate. According to this method, a semiconductor element can be more finely formed, and further, the semiconductor element can be arranged on the glass substrate, together with a polysilicon thin film transistor (TFT) and the like, which can be prepared on the glass substrate. Therefore, a desired high-speed circuit can be formed.

However, in this case, a large amount of hydrogen ions or helium needs to be previously implanted into a single crystal silicon layer before the transfer, because the single crystal silicon layer of the semiconductor element is cleaved after the transfer. Accordingly, hydrogen or helium remaining in the semiconductor element needs to be removed after the cleavage of the single crystal silicon layer, and in addition, a thermal treatment needs to be performed in order to recover crystal defects due to the hydrogen ion or helium implantation and the cleavage of the single crystal silicon layer. As a result, the production steps are complicated. In this point, there is still room for improvement.

As a production method of a semiconductor element, a method in which a polycrystalline silicon layer and a titanium layer are formed on a single crystal silicon substrate, and a titanium silicide layer is formed from polycrystalline silicon and titanium, and then, an aluminum wiring is formed on the titanium silicide layer, is disclosed (for example, refer to Patent Document 1). According to this production method, the titanium silicide layer is formed between the single crystal silicon substrate and the aluminum wiring, thereby achieving a reduction in resistance of the semiconductor element.
[Patent Document 1]
   Japanese Kokai Publication No. Hei-03-55829

### DISCLOSURE OF INVENTION

The present invention has been made in view of the above-mentioned state of the art. The present invention has an obj ect to provide a production method of a semiconductor device, a production method of a display device, a semiconductor device, a production method of a semiconductor element, and a semiconductor element, each capable of providing a lower-resistance semiconductor element which is more finely prepared through more simple steps.

The present inventors made various investigations on a production method of a semiconductor device, capable of more finely preparing a lower-resistance semiconductor element through more simple steps. The inventors found the followings. By forming a silicon layer and a metal layer of a semiconductor element and then, transferring the semiconductor element onto a substrate, microfabrication of the silicon layer and the metal layer, which can not be performed on the substrate after the transfer, can be performed. As a result, the semiconductor element can be more finely prepared. The inventors also found the followings. The resistance of the semiconductor element can be decreased while an increase in resistance of the semiconductor element is prevented, by forming metal silicide from silicon for a metal layer-side part of the silicon layer and metal for a silicon layer-side part of the metal layer by heating. This is because not the entire silicon layer is converted into metal silicide. Further, the inventors found the followings. The semiconductor element is transferred onto the substrate and then, the heating is performed to form the metal silicide, and thereby, removal of hydrogen and the like remaining in the semiconductor element, recovery of crystal defects caused by the cleavage of the silicon layer, can be simultaneously performed. Therefore, the production steps can be simplified. As a result, the above-mentioned problems have been admirably solved, leading to completion of the present invention.

That is, the present invention is a production method of a semiconductor device including a semiconductor element on a substrate, wherein the production method comprises a metal silicide-forming step of: transferring the semiconductor element onto the substrate, the semiconductor element having a multilayer structure of a silicon layer and a metal layer, and by heating, forming metal silicide from silicon for a metal layer-side part of the silicon layer and metal for a silicon layer-side part of the metal layer.

According to the production method of the semiconductor device of the present invention, a semiconductor device including a semiconductor element on a substrate is produced. An element that is suitable for an integrated circuit is preferable as the above-mentioned semiconductor element. Examples of the semiconductor element include: a silicon element; and circuit elements having a MOS structure, such as a MOS diode and a MOS transistor. The semiconductor device is not especially limited. Examples of such a semiconductor device include an active matrix substrate that is included in an active matrix driving liquid crystal display device or an organic electroluminescent display device. The semiconductor device may have components other than the semiconductor element on the substrate, and it may have an amorphous silicon thin film transistor (TFT), a polysilicon TFT, and the like. An insulating substrate such as a glass substrate and a plastic substrate is preferable as the substrate.

The above-mentioned production method includes the metal silicide-forming step of transferring the semiconductor element having a multilayer structure of a silicon layer and a metal layer onto the substrate, and by heating, forming metal silicide from silicon for a metal layer-side part of the silicon layer and metal for a silicon layer-side part of the metal layer. According to this, the silicon layer and the metal layer of the semiconductor element are formed before the semiconductor element is transferred onto the substrate. Accordingly, microfabrication of the silicon layer, the metal layer, and the like, which can not be performed on the substrate after the transfer, can be achieved. As a result, the semiconductor element can be more finely prepared. That is, a high-performance semiconductor element of sub-micron order can be formed on a glass substrate and the like. Further, if the semiconductor element is transferred onto the substrate, the finely-processed semiconductor element can be arranged on the substrate, together with an amorphous silicon TFT, a polysilicon TFT, and the like, which has been prepared on the substrate. So, a high-speed circuit can be formed on the substrate. In addition, not the entire silicon layer is infiltrated with the metal for the silicon layer-side part of the metal layer. Accordingly, an increase in resistance of the semiconductor element, which is caused when the entire silicon layer is converted into metal silicide, can be prevented. Further, if the heating for formingmetal silicide is performed, hydrogen remaining in the semiconductor element can be removed and crystal defects caused by the cleavage of the silicon layer, and the like, can be recovered, for example. So, the number of times of the heating can be reduced, and as a result, the production steps can be simplified. Further, the metal silicide layer is formed between the silicon layer and the metal layer, and thereby a contact resistance at the interface between the silicon layer and the metal layer can be decreased, compared to an embodiment in which the silicon layer and the metal layer are directly in contact with each other. The semiconductor element may be transferred onto the substrate after being chipped, or may be transferred onto it without being chipped.

The method of transferring the above-mentioned semiconductor element onto the substrate is not especially limited. The following methods are mentioned, for example: a method of bonding the semiconductor element to a surface of the substrate, with an epoxy or acrylic adhesive; and a method of activating a surface of the semiconductor element and a surface of the substrate by SC-1, and then bonding these surfaces to each other. The method of the heating for forming the metal silicide is not especially limited, and furnace annealing using a furnace and the like, RTA (rapid thermal annealing), and the like, are mentioned.

Examples of a material for the above-mentioned silicon layer include amorphous silicon, polysilicon, continuous grain (CG) silicon, single crystal silicon. Single crystal silicon is preferable in order to more finely form the semiconductor element and in view of device characteristics of the semiconductor element. The silicon layer may have a single layer structure or may have a multi-layer structure. If the silicon layer has a multi-layer structure, the layers may be made of the same material, or may be made of different materials. The silicon layer may have a substrate shape. That is, the silicon layer may be a silicon substrate (single crystal silicon substrate and the like).

The material for the above-mentioned metal layer is not especially limited. An aluminum (Al) metal is preferable in view of a reduction in resistance of the semiconductor element. A high-melting-point metal having a melting point of 1200°C or more is more preferable and a high-melting-point having a melting point of 1400°C or more is still more preferable, in order that a short-circuit caused by a hillock, an increase in resistance caused by a reaction, and the like, are prevented from being caused by the heating.

The production method of the semiconductor device, according to the present invention, is not especially limited as long as the above-mentioned metal silicide-forming step is essentially included. The production method may or may not include other steps. It is preferable that the production method of the semiconductor device, of the present invention, includes a step of implanting a large amount of hydrogen ions or helium into the silicon layer before the semiconductor element is transferred, in order to cleave the silicon layer of the semiconductor element after the semiconductor element is transferred onto the substrate.

Preferable embodiments of the production method of the semiconductor device of the present invention are mentioned.
As a preferable embodiment of the above-mentioned metal layer, an embodiment in which the metal layer has a structure in which the first metal layer and the second metal layer are stacked in this order from the silicon layer side is mentioned. That is, it is preferable that the semiconductor element has, as the metal layer, a first metal layer made of a first metal, and a second metal layer made of a second metal different from the first metal, and the metal silicide is formed from silicon for the first metal layer-side of the silicon layer and the first metal for the first metal layer. "The first metal layer" used herein means a layer that is formed by the heating for forming the metal silicide and made of the metal (the first metal) which forms the metal silicide together with the silicon. "The second metal layer" used herein means a layer that is formed by the heating for forming the metal silicide and made of the metal (the secondmetal) which does not form the metal silicide together with the silicon. According to this, the first metal for the first metal layer is entirely converted into metal silicide, but the second metal for the second metal layer is not converted into metal silicide. So, by adjusting the thickness of the first metal layer, the increase in resistance of the semiconductor element, which is caused when the entire silicon layer is converted into metal silicide, can be easily prevented.

The above-mentioned first metal layer may have a single layer structure or may have a multi-layer structure. If the first metal layer has a multi-layer structure, the layers may be made of the same material or may be made of different materials. It is preferable that the layers are made of the same material in order to form homogeneous metal silicide.

The above-mentioned second metal layer is made of a metal different from that for the first metal layer. The second metal layer may have a single layer structure or may have a multi-layer structure. If the secondmetal layer has a multi-layer structure, the layers may be made of the same material or may be made of different materials.

The embodiment of the semiconductor element having a structure in which the silicon layer, the first metal layer, and the second metal layer are stacked in this order is not especially limited, and the following embodiments (1) and (2) are mentioned, for example. (1) An embodiment in which the silicon layer, an insulating film, and the second metal layer are stacked in this order; the insulating film is provided with an opening for connecting the silicon layer to the second metal layer; and the first metal layer is formed inside the opening, and (2) an embodiment in which an insulating film is stacked on the silicon layer; the insulating film is provided with an opening; and the first metal layer and the second metal layer are stacked in this order inside the opening.

It is preferable that the first metal layer has a thickness that accounts for 30% or less of a thickness of the silicon layer just before forming the metal silicide. If it accounts for more than 30%, the thickness of the silicon layer which is not converted into metal silicide is small and the silicon layer is broken, and as a result, an electrical contact through the silicon layer might be lost. From the same viewpoint, it is more preferable that the first metal layer has a thickness that accounts for 20% or less of a thickness of the silicon layer just before forming the metal silicide.

The first metal layer is preferably made of a transition metal, and more preferably made of at least one metal selected from the group consisting of: titanium (melting point: 1660°C, molybdenum (melting point: 2620°C), tungsten (melting point: 3400°C), tantalum (melting point: 2990°C), cobalt (melting point: 1490°C), nickel (melting point: 1450°C), platinum (melting point: 1770°C), and rhodium (melting point: 1970°C). These transition metals can easily produce metal silicide together with silicon, by heating, and therefore, they can easily reduce the contact resistance at the interface between the silicon layer and the metal layer. These transition metals each have a melting point of 1400°C or more, and so, even if the heating for forming the metal silicide is performed, a hillock is not generated and the resistance is not increased by a reaction.

It is still more preferable that the first metal layer is made of titanium because titanium silicide (TiSi₂) has a low resistance and excellent thermal stability as the metal silicide. In view of easy handling, the first metal layer is more preferably made of nickel, and still more preferably cobalt, and particularly preferably titanium. Further, it is preferable that the second metal layer is made of titanium nitride (melting point: 2950°C) . In view of operation and effects of the present invention, it is preferable that the first metal layer is made of titanium, and the second metal layer is made of titanium nitride.

It is preferable that the substrate is a glass substrate with a strain point of 650°C or more (hereinafter, also referred to as a "high-strain-point glass substrate") . If the substrate has a strain point of less than 650°C, the substrate is strained by the heating for forming the metal silicide, which fails to accurately position the semiconductor element on the substrate in a step that is performed afterward. X-ray diffraction, Raman scattering, and the like, are mentioned as a measurement method of the strain point.

It is preferable that the metal silicide is formed by heating at 700°C or less if the substrate is the high-strain-point glass substrate, for example. If the heating is performed at more than 700°C, the glass substrate and the like is possibly strained even if the heating is performed for a short time. If a substrate has a heat-resistant temperature higher than that of the high-strain-point glass substrate, (e.g., quartz substrate), the metal silicide may be formed by heating at more than 700°C. However, it is preferable that the heating is performed at 900°C or less in order not to deteriorate the characteristics of the semiconductor element. In addition, it is preferable that the metal silicide is formed by heating at 600°C or more. If the heating is performed at less than 600°C, the silicon and the metal might be insufficiently converted into the metal silicide, or the characteristics of the silicon might not be recovered.

It is preferable that the production method of the semiconductor device includes a separation layer-forming step of implanting a hydrogen ion or helium into the silicon layer from a side of the metal layer, thereby forming a separation layer, before the semiconductor element is transferred onto the substrate. If the semiconductor element is transferred onto the substrate, a silicon layer with a large thickness is generally used as the silicon layer (silicon substrate and the like) of the semiconductor element, in view of strength and the like. Accordingly, the separation layer is formed in the silicon layer and using this separation layer, the silicon layer is cleaved. As a result, the silicon layer can be easily thinned to have a proper thickness. If the above-mentioned separation layer-forming step is performed after the semiconductor element is transferred, additional processes such as those which need handling technique must be performed. So, it is preferable that the separation layer-forming step is performed before the semiconductor element is transferred. If, in the above-mentioned separation layer-forming step, the hydrogen ion or the helium is charged into the silicon layer from a side opposite to the metal layer side, the separation layer can not be formed at a desired position, because of the thickness of the silicon layer, an accelerating voltage, and the like. As a result, the thickness of the silicon layer might not be properly adjusted. So, it is preferable that the hydrogen ion or the helium is implanted into the silicon layer from the metal layer side.

It is preferable that the production method of the semiconductor device includes a cleavage step of cleaving the silicon layer using the separation layer, before the metal silicide is formed. According to this, not only in the below-mentioned etching step but also in this step, the thickness of the silicon layer used for forming the metal silicide, and the thickness of the silicon layer in the channel region can be properly adjusted. The above-mentioned cleavage step may be performed before the semiconductor element is transferred or may be performed after it is transferred as long as the cleavage step is performed before the metal silicide is formed. It is preferable that the cleavage step is performed after the semiconductor element is transferred in order to prevent the silicon layer from being damaged, e.g., cracked, at the time when the semiconductor element is transferred. That is, it is more preferable in the production method of the semiconductor device that the semiconductor element is transferred onto the substrate, and then, the cleavage step of cleaving the silicon layer using the separation layer is performed, and after that, the metal silicide is formed. The cleavage method of the silicon layer is not especially limited, but heating is preferable. If heating is employed, the hydrogen or the helium in the separation layer is gasified and expanded, which permits easily cleavage of the silicon layer. If a surface of the semiconductor element and a surface of the substrate are activated by SC-1 and then, these surfaces are bonded to each other, the bonding strength can be enhanced. RTA, furnace annealing using a furnace, and the like, are mentioned as a method of the heating for cleaving the silicon layer. The heating for cleaving the silicon layer is performed at 500 to 650°C, and so, the above-mentioned conversion into the metal silicide does not occur, generally.

It is preferable that the production method of the semiconductor device includes an etching step of etching the silicon layer that has been cleaved, before the metal silicide is formed. If the thickness of the silicon layer is adjusted only by the cleavage, the semiconductor characteristics might be adversely affected because the separation layer containing a high concentration of the hydrogen ion or the helium is formed near the channel region and the concentration of the hydrogen ion or the helium in the channel region is increased. That is, the thickness of the silicon layer is adjusted by both of the cleavage and the etching, and thereby a silicon layer having a flat surface can be formed without adverse effects on the semiconductor characteristics. The thickness of the silicon layer can be more precisely adjusted. Wet etching, dry etching, and the like, are mentioned as the etching, and dry etching is preferable. This is because in the wet etching, an etching rate is low, and a substrate onto which the semiconductor element is to be transferred might be damaged, and further because a step of protecting other elements which has been formed on the substrate from the etching is additionally needed.

If the cleavage step and the etching step are performed before the semiconductor element is transferred, the thickness of the silicon layer is small at the time of the transfer, and so, it is highly likely that the silicon layer may be cracked. Accordingly, it is more preferable in the production method of the semiconductor device that the semiconductor element is transferred, and then, the cleavage step and the etching step are performed, and after that, the metal silicide is formed.

The present invention is also a production method of a display device, including the production method of the semiconductor device. According to the production method of the semiconductor device of the present invention, a lower-resistance semiconductor element can be more finely formed through more simple steps. So, a lower-power-consumption display device capable of displaying a higher-definition and high-speed image can be provided. The display device is not especially limited, and for example, mobile equipments such as a cellular phone and a PDA, a system LCD, and an electronic paper, are mentioned.

The present invention is a semiconductor device produced using the production method of the semiconductor device. According to the production method of the semiconductor device of the present invention, a lower-resistance semiconductor element can be more finely prepared through more simple steps, and so, a lower-power-consumption and high-speed semiconductor device that can be produced at low costs can be provided.

The semiconductor device of the present invention is not especially limited as long as it includes a semiconductor element on a substrate. The configuration of the semiconductor device of the present invention is not especially limited. The semiconductor device is produced using the production method of the semiconductor device of the present invention, and so, the semiconductor element in the semiconductor device has a structure in which a silicon layer, a metal silicide layer, and a metal layer are stacked in this order, and the cross section of the silicon layer has an depression at a part of the upper surface, and the metal silicide layer is arranged on the depression of the upper surface of the silicon layer. According to such a semiconductor device, a contact resistance between the silicon layer and the metal layer can be reduced.

The present invention is further a production method of a semiconductor element having a multi-layer structure of a silicon layer and a metal layer, wherein the production method includes a metal silicide-forming step of forming metal silicide from silicon for a metal layer-side part of the silicon layer and metal for a silicon layer-side part of the metal layer, by heating. According to this production method, the metal silicide layer is formed between the silicon layer and the metal layer, and thereby a contact resistance at the interface between the silicon layer and the metal layer can be decreased. In addition, not the entire silicon layer is infiltrated with the metal for the silicon layer-side part of the metal layer. Accordingly, an increase in resistance of the semiconductor element, which is caused when the entire silicon layer is converted into metal silicide, can be prevented. An element that is suitable for IC is preferable as the above-mentioned semiconductor element. Examples of the semiconductor element include: a silicon element; and circuit elements having a MOS structure, such as a MOS diode and a MOS transistor.

The production method of the semiconductor element of the present invention is not especially limited as long as the above-mentioned metal silicide-forming step is essentially included. The production method may or may not include other steps.

Preferable embodiments of the production method of the semiconductor element of the present invention are mentioned. In the preferable embodiments of the production method of the semiconductor element of the present invention, operation and effects are exhibited on the basis of the same principle as in the corresponding preferable embodiments of the production method of the semiconductor device of the present invention.
In the above-mentioned metal silicide-forming step, it is preferable that the semiconductor element has, as the metal layer, a first metal layer made of a first metal, and a second metal layer made of a second metal different from the first metal, and the metal silicide is formed from silicon for the first metal layer-side of the silicon layer and the first metal for the first metal layer.

It is preferable that the first metal layer has a thickness that accounts for 30% or less of a thickness of the silicon layer just before forming the metal silicide.
It is preferable that the first metal layer has a thickness that accounts for 20% or less of a thickness of the silicon layer just before forming the metal silicide.
It is preferable that the first metal layer is made of at least one metal selected from the group consisting of titanium, molybdenum, tungsten, tantalum, cobalt, nickel, platinum, and rhodium.
It is preferable that the first metal layer is made of titanium, and the second metal layer is made of titanium nitride.
It is preferable in the production method of the semiconductor element that before the metal silicide is formed, the followingtwo steps are performed: a separation layer-forming step of implanting a hydrogen ion or helium into the silicon layer from a side of the metal layer, thereby forming a separation layer; and a cleavage step of cleaving the silicon layer using the separation layer.
It is preferable that the production method of the semiconductor element includes an etching step of etching the silicon layer that has been cleaved, before the metal silicide is formed.

The present invention is also a semiconductor element produced using the production method of the semiconductor element. According to the production method of the semiconductor element of the present invention, the resistance of the semiconductor element can be reduced. Further, a lower-power-consumption and higher-speed semiconductor element can be provided.

The configuration of the semiconductor element of the present invention is not especially limited. The semiconductor element is produced using the production method of the semiconductor element of the present invention, and so, the semiconductor element has a structure in which a silicon layer, a metal silicide layer, and a metal layer are stacked in this order, and the cross section of the silicon layer has a depression at a part of the upper surface, and the metal silicide layer is arranged on the depression of the upper surface of the silicon layer. According to such a semiconductor element, the contact resistance between the silicon layer and the metal layer can be reduced.

### EFFECT OF THE INVENTION

According to the production method of the semiconductor device of the present invention, a lower-resistance semiconductor element can be more finely formed through more simple production steps.

### BEST MODES FOR CARRYING OUT THE INVENTION

The present invention is mentioned in more detail below with reference to the following Embodiments, but not limited to only these Embodiments.

### (Embodiment 1)

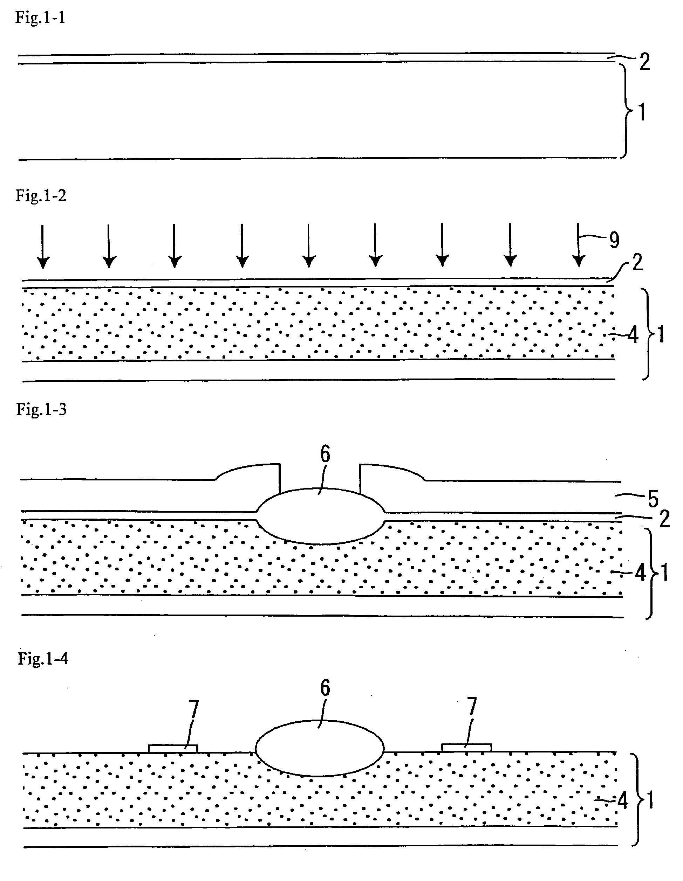

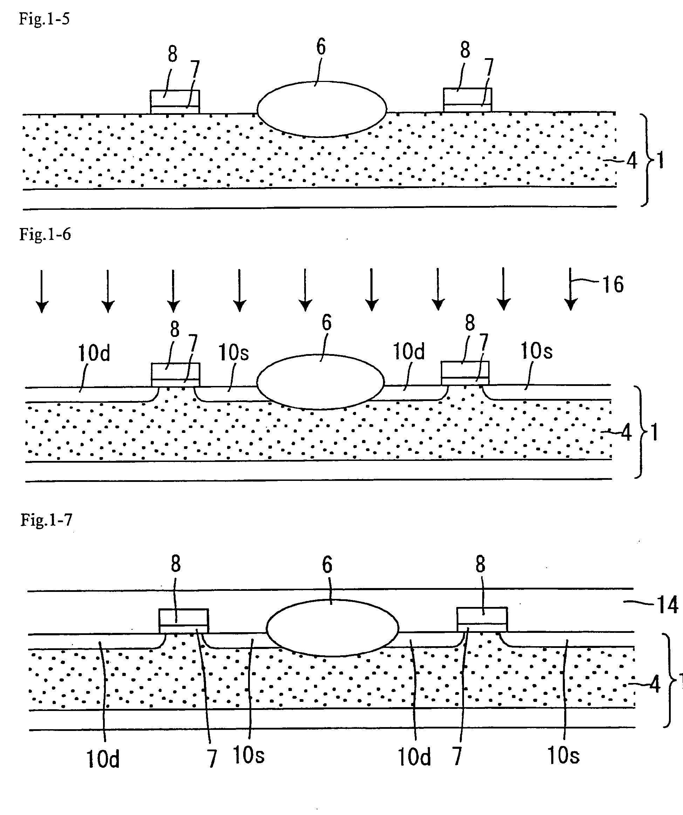

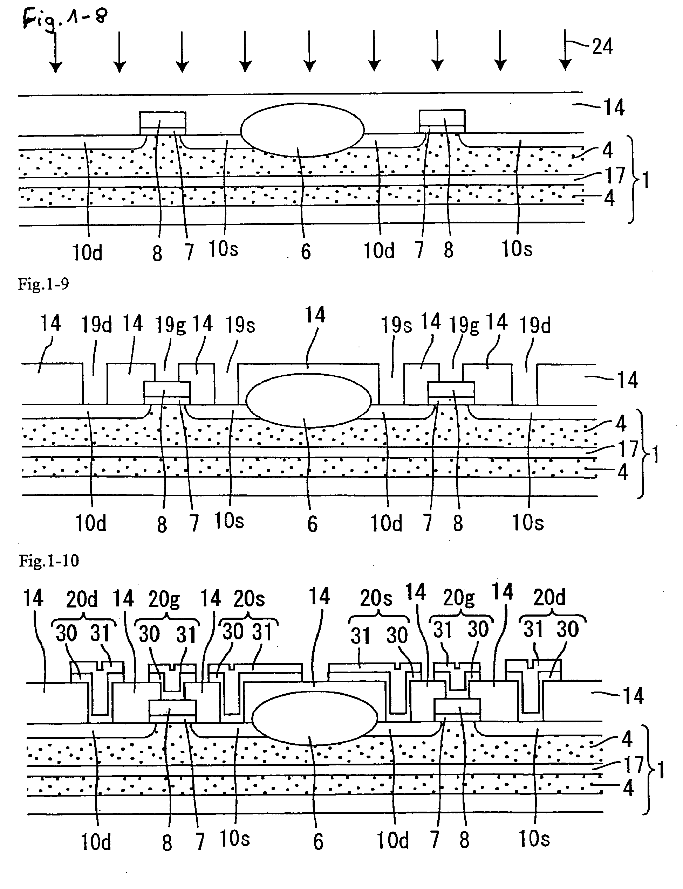

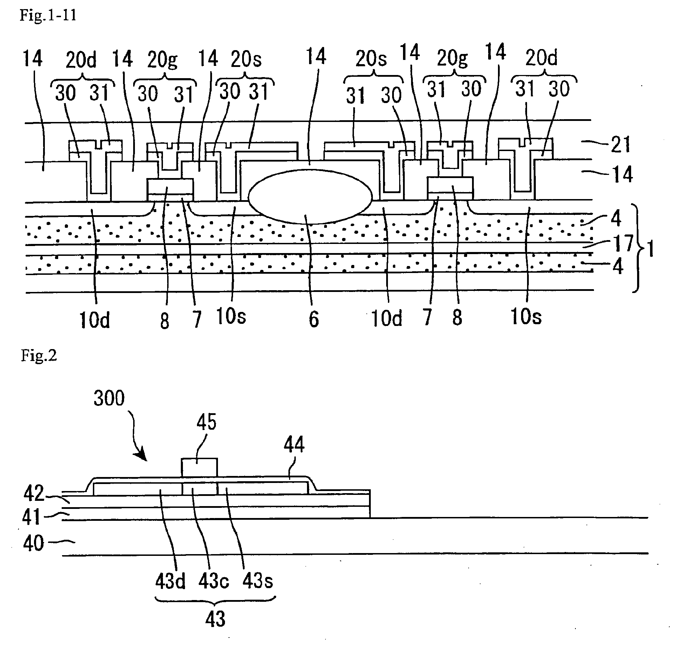

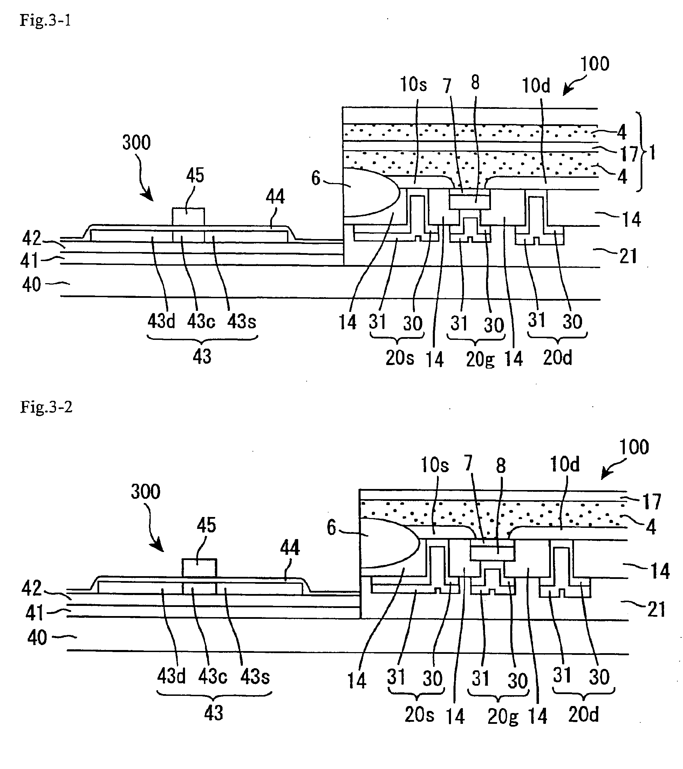

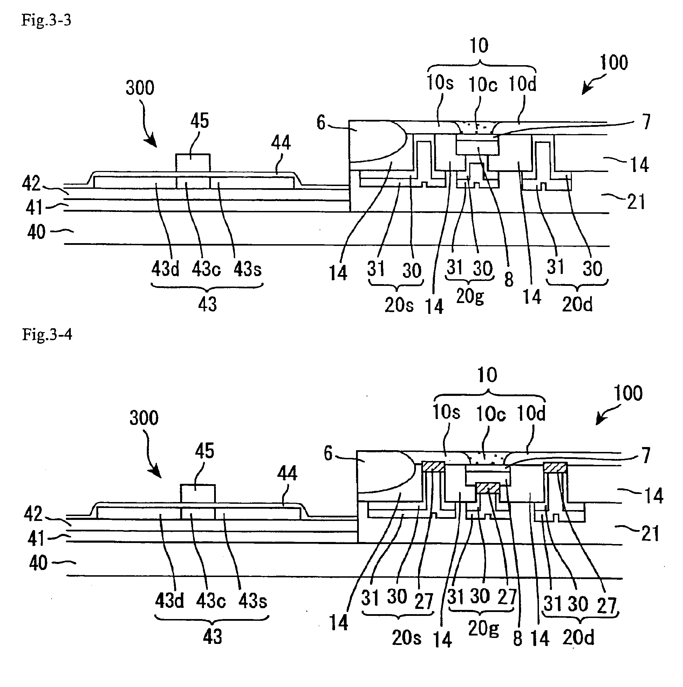

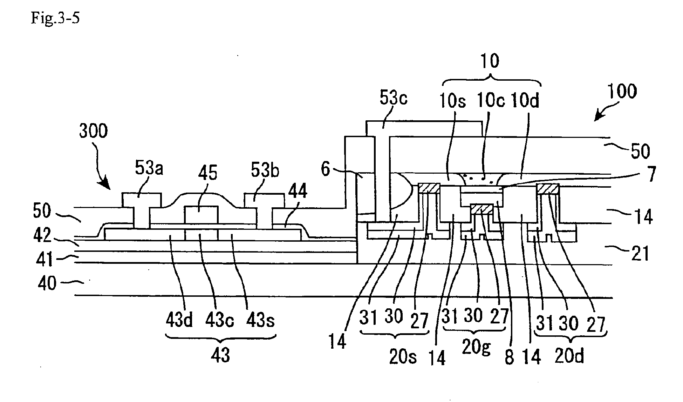

Figs. 1-1 to 1-11, Fig. 2, and Figs. 3-1 to 3-5 are cross-sectional views schematically showing production steps of a semiconductor device in accordance with Embodiment 1.
(1) Production of single crystal silicon element (semiconductor element) (Figs. 1-1 to 1-11), (2) production of substrate onto which single crystal silicon chip is transferred (Fig. 2), and (3) production of semiconductor device (Figs. 3-1 to 3-5) are mentioned below.

### (1) Production of single crystal silicon element (Figs. 1-1 to 1-11)

A thermal oxide film 2 is formed on a single crystal silicon substrate (single crystal silicon wafer) 1 by rapid oxidation and the like, first, as shown in Fig. 1-1.
Ions of boron 9 are implanted into the inside of the single crystal silicon substrate 1 by ion implantation, ion doping, and the like, as shown in Fig. 1-2. Successively, the implanted boron 9 ions are diffused and activated by thermal treatment, thereby forming a P-well region 4.

A silicon nitride (SiNₓ) film 5 is pattern-formed on the thermal oxide film 2 by Plasma CVD (chemical vapor deposition) and the like, and then LOCOS (local oxidation of silicon) is performed using the SiNₓ film 5 as a mask to give a LOCOS oxide film 6, as shown in Fig. 1-3.

The SiNₓ film 5 and the thermal oxide film 2 are removed by etching and then, a gate oxide film 7 is formed by thermal oxidation, as shown in Fig. 1-4.
Then, a gate electrode 8 is pattern-formed frompolysilicon (p-Si), as shown in Fig. 1-5. The gate electrode 8 has a thickness of 300 nm.

The P-well region 4 is doped with phosphorus 16 by ion implantation, ion doping, and the like, using the gate electrode 8 as a mask, thereby forming N-type high concentration impurity regions 10s and 10d, as shown in Fig. 1-6.

An interlayer insulating film 14 made of SiO₂ is formed by plasma CVD and the like, and then, the interlayer insulating film 14 surface is flattened by CMP (chemical mechanical planarization), as shown in Fig. 1-7.

Then, hydrogen ions 24 are implanted into the single crystal silicon substrate 1 through the interlayer insulating film 14 by ion implantation, as shown in Fig. 1-8. Thus, a hydrogen-implanted region 17 is formed in the P-well region 4, as shown in Fig. 1-9.

The interlayer insulating film 14 is provided with a gate contact hole 19g, a source contact hole 19s, and a drain contact hole 19d, by dry etching and the like, and then, a titanium (Ti) film, and a titanium nitride (TiN) film are formed in this order by sputtering, and the like, as shown in Fig. 1-9. The thicknesses are 30 nm for the Ti film and 500 nm for the TiN film. The Ti film and the TiN film may not be necessarily formed by sputtering, and may be formed by CVD, for example.

A photoresist is applied on the TiN film, and then exposed and patterned. The TiN film and the Ti film are patterned by dry etching, and thereby, a Ti layer (the first metal layer) 30 and a TiN layer (the second metal layer) 31 are formed, as shown in Fig. 1-10. As a result, a gate wiring 20g, a source electrode wiring 20s, and a drain electrode wiring 20d are formed.

A tetraethoxy silane (TEOS) film 21 is formed by plasma CVD and then the film 21 surface is flattened by CMP, as shown in Fig. 1-11.
Then, the single crystal silicon element is processed into a desired size, thereby preparing a single crystal silicon chip.

### (2) Production of substrate onto which single crystal silicon chip is to be transferred (Fig. 2)

As shown in Fig. 2, on a glass substrate 40 onto which the single crystal silicon chip is to be transferred, a polysilicon (p-Si) TFT 300 is formed. The glass substrate 40 surface in a region where the single crystal silicon chip is to be transferred is previously exposed by etching. Instead of the glass substrate 40 surface, the SiO₂ film 42 surface may be exposed by forming a SiO₂ film 42 also in the region where the single crystal silicon chip is to be transferred. According to the present Embodiment, a high-strain-point glass substrate with a strain point of 650°C is used as the glass substrate 40, and so, the glass substrate 40 is not strained by the thermal treatment after the transfer, and therefore, the glass substrate 40 is accurately positioned on the substrate in a step that is performed afterward.

### (3) Production of semiconductor device (Figs. 3-1 to 3-5)

As shown in Fig. 3-1, organic substances on the TEOS film 21 surface in the single crystal silicon chip 100 and the glass substrate 40 surface are removed, and the both surfaces are activated by SC-1, and then, the single crystal silicon chip 100 is bonded to the glass substrate 40 surface.

As shown in Fig. 3-2, a thermal treatment is performed at 630°C by RTA, thereby separating a bulk single crystal silicon that is on the hydrogen-implanted region 17 from the single crystal silicon substrate 1 (cleavage of the single crystal silicon substrate 1). By the thermal treatment, the hydrogen inside the hydrogen-implantedregion 17 is gasified and expanded, and as a result, the silicon layer can be easily cleaved. The bonding strength at the interface between TEOS film 21 of the single crystal silicon chip 100 and the glass substrate 40 can be enhanced. Then, as shown in Fig. 3-3, the single crystal silicon substrate 1 is dry-etched in such a way that the surface or inside of the LOCOS oxide film 6 is exposed using gaseous mixture of carbon tetrafluoride (CF₄) and oxygen (O₂) as etching gas. The thickness of the single crystal silicon layer 10 composed of the N-type high concentration impurity regions 10s and 10d, and the P-type channel region 10c is adjusted to 150 nm.

Then, the glass substrate onto which the single crystal silicon chip 100 has been transferred is thermally treated at 680°C by furnace annealing or RTA. As a result, a titanium silicide layer (metal silicide layer) 27 can be formed from titanium constituting the Ti layer 30 and silicon constituting a Ti layer 30-side part of the single crystal silicon layer 10, and also, the titanium silicide layer 27 can be formed from titanium constituting the Ti layer 30 and silicon constituting a Ti layer 30-side part of the gate electrode (polysilicon layer) 8. As a result, hydrogen remaining in the single crystal silicon chip 100 can be removed and simultaneously, crystal defects caused by the hydrogen ion implantation and the cleavage of the single crystal silicon substrate 1 can be recovered. Thus, the characteristics of the single crystal silicon chip 100 can be improved.

Finally, an interlayer insulating film 50 is formed and provided with contact holes, and then thereon, a metal film for wirings is formed and patterned by etching, thereby forming wirings 53a to 53c, as shown in Fig. 3-5.

According to the production steps of the present Embodiment, the production of the single crystal silicon element (processing of the single crystal silicon substrate 1, formation of the Ti layer 30 and the TiN layer 31, and formation of the contact holes 19g, 19s, and 19d) is performed before the single crystal silicon chip 100 is transferred onto the glass substrate 40. So, the microfabrication for the single crystal silicon layer 10, the Ti layer 30, the TiN layer 31, and the contact holes 19g, 19s, and 19d, which can not be performed after the chip 100 is transferred onto the glass substrate 40, can be performed. As a result, the single crystal silicon chip 100 can be more finely prepared. Further, the step of transferring the single crystal silicon chip 100 onto the glass substrate 40 is performed, and thereby the finely-processed single crystal silicon chip 100 can be arranged on the glass substrate 40, together with the polysilicon TFT 300. Therefore, a high-speed circuit can be formed on the glass substrate 40.

Further, by the titanium silicide-forming step, the titanium silicide layers 27 are each formed between the N-type high concentration impurity region 10s and the TiN layer 31; between the N-type high concentration impurity region 10d and the TiN layer 31; and between the gate electrode 8 and the TiN layer 31. As a result, the contact resistance can be reduced, compared to embodiments where each of the N-type high concentration impurity regions 10s and 10d is directly connected to the TiN layer 31, and where the gate electrode 8 is directly connected to the TiN layer 31. Further, in the titanium silicide-forming step, TiN for the TiN layer 31 does not form metal silicide, together with silicon, and only about 70 nm of the single crystal silicon layer is consumed for the Ti layer 30 with a thickness of 30 nm (accounting for 20% of the thickness of the single crystal silicon layer), and so, the single crystal silicon layer with a thickness of about 80 nm remains (refer to the following Table 1). Accordingly, the increase in resistance, caused when the entire silicon layer that is in contact with the gate wiring 20g, the source electrode wiring 20s, and the drain electrode wiring 20d is converted into metal silicide, can be prevented.

The single crystal silicon chip 100 is transferred onto the glass substrate 40, and then the titanium silicide-forming step is performed. By the thermal treatment for forming the titanium silicide, removal of hydrogen remaining in the single crystal silicon chip 100 and recovery of the crystal defects due to the cleavage of the single crystal silicon substrate 1, and the like, can be simultaneously performed. Further, the number of times of the thermal treatment can be decreased. As a result, the production steps can be simplified.

In addition, the gate wiring 20g, the source electrode wiring 20s, and the drain electrode wiring 20d are made of Ti (melting point: 1660°C) and TiN (melting point: 2950°C ) each of which has a melting point higher than that of aluminum (melting point: 660.4°C) . As a result, a short-circuit caused by a hillock, an increase in resistance caused by a reaction, and the like, can be prevented from being caused by the thermal treatment, which is performed after the transfer.

### (Embodiment 2)

The present Embodiment is the same as Embodiment 1, except that the thickness of the single crystal silicon layer 10 after being etched in such a way that the surface or inside of the LOCOS oxide film 6 is exposed (the thickness of the single crystal silicon layer just before forming the metal silicide) is 80 nm; and a Ti layer with a thickness of 20 nm (accounting for 25% of the thickness of the single crystal silicon layer) is used instead of the Ti layer 30 with a thickness of 30 nm. Only about 46 nm of the single crystal silicon layer is consumed for the Ti layer with a thickness of 20 nm, and so, the single crystal silicon layer with a thickness of about 34 nm remains.
Accordingly, the same operation and effects as in Embodiment 1 can be exhibited by the present Embodiment.

### (Embodiment 3)

The present Embodiment is the same as Embodiment 1, except that a cobalt layer (melting point: 1490°C) with a thickness of 20 nm (accounting for 13% of the thickness of the single crystal silicon layer) is used instead of the Ti layer 30 with a thickness of 30 nm. Only about 70 nm of the single crystal silicon layer is consumed for the cobalt layer with a thickness of 20 nm, and so, the single crystal silicon layer with a thickness of about 80 nm remains.
Accordingly, the same operation and effects as in Embodiment 1 can be exhibited by the present Embodiment.

### (Embodiment 4)

The present Embodiment is the same as Embodiment 1, except that the thickness of the single crystal silicon layer 10 after being etched in such a way that the surface or inside of the LOCOS oxide film 6 is exposed (the thickness of the single crystal silicon layer just before forming the metal silicide) is 100 nm; and a nickel layer (melting point: 1450°C) with a thickness of 20 nm (accounting for 20% of the thickness of the single crystal silicon layer) is used instead of the Ti layer 30 with a thickness of 30 nm. Only about 40 nm of the single crystal silicon layer is consumed for the nickel layer with a thickness of 20 nm, and so, the single crystal silicon layer with a thickness of about 60 nm remains.
Accordingly, the same operation and effects as in Embodiment 1 can be exhibited by the present Embodiment.

### (Embodiment 5)

The present Embodiment is the same as Embodiment 1, except that the thickness of the single crystal silicon layer 10 after being etched in such a way that the surface or inside of the LOCOS oxide film 6 is exposed (the thickness of the single crystal silicon layer just before forming the metal silicide) is 650 nm; a cobalt layer with a thickness of 20 nm (accounting for 8% of the thickness of the single crystal silicon layer) is used instead of the Ti layer 30 with a thickness of 30 nm; and the TiN layer 31 has a thickness of 800 nm. Only about 182 nm of the single crystal silicon layer is consumed for the cobalt layer with a thickness of 20 nm, and so, the single crystal silicon layer with a thickness of about 468 nm remains.
Accordingly, the same operation and effects as in Embodiment 1 can be exhibited by the present Embodiment.

### (Embodiment 6)

The present Embodiment is the same as Embodiment 1, except that the thickness of the single crystal silicon layer 10 after being etched in such a way that the surface or inside of the LOCOS oxide film 6 is exposed (the thickness of the single crystal silicon layer just before forming the metal silicide) is 300 nm; a cobalt layer with a thickness of 15 nm (accounting for 5% of the thickness of the single crystal silicon layer) is used instead of the Ti layer 30 with a thickness of 30 nm; and the TiNx layer 31 has a thickness of 600 nm. Only about 54 nm of the single crystal silicon layer is consumed for the cobalt layer with a thickness of 15 nm, and so, the single crystal silicon layer with a thickness of 246 nm remains.
Accordingly, the same operation and effects as in Embodiment 1 can be exhibited by the present Embodiment.

### (Embodiment 7)

The present Embodiment is the same as Embodiment 1, except that the thickness of the single crystal silicon layer 10 after being etched in such a way that the surface or inside of the LOCOS oxide film 6 is exposed (the thickness of the single crystal silicon layer just before forming the metal silicide) is 700 nm; a tungsten layer (melting point: 3400°C) with a thickness of 60 nm (accounting for 9% of the thickness of the single crystal silicon layer) is used instead of the Ti layer 30 with a thickness of 30 nm; and the thickness of the TiN layer 31 is 900 nm. Only 152 nm of the single crystal silicon layer is consumed for the tungsten layer with a thickness of 60 nm, and so, the single crystal silicon layer with a thickness of 548 nm remains.
Accordingly, the same operation and effects as in Embodiment 1 can be exhibited by the present Embodiment.

### (Embodiment 8)

The present Embodiment is the same as Embodiment 1, except that the thickness of the single crystal silicon layer 10 after being etched in such a way that the surface or inside of the LOCOS oxide film 6 is exposed (the thickness of the single crystal silicon layer just before forming the metal silicide) is 85 nm; a nickel layer with a thickness of 25 nm (accounting for 29% of the thickness of the single crystal silicon layer) is used instead of the Ti layer 30 with a thickness of 30 nm; and the thickness of the TiN layer 31 is 500 nm. Only 46 nm of the single crystal silicon layer is consumed for the nickel layer with a thickness of 25 nm, and so, the single crystal silicon layer with a thickness of 39 nm remains.
Accordingly, the same operation and effects as in Embodiment 1 can be exhibited by the present Embodiment.

The present application claims priority under the Paris Convention and the domestic law in the country to be entered into national phase on Patent Application No. 2007-2821 filed in Japan on January 10, 2007, the entire contents of which are hereby incorporated by reference.

### BRIEF DESCRIPTION OF DRAWINGS

[Fig. 1-1]
   Fig. 1-1 is a cross-sectional view schematically showing the thermal oxide film-forming step in accordance with Embodiment 1.
[Fig. 1-2]
   Fig. 1-2 is a cross-sectional view schematically showing the P-well region-forming step in accordance with Embodiment 1.
[Fig. 1-3]
   Fig. 1-3 is a cross-sectional view schematically showing the LOCOS oxide film-forming step in accordance with Embodiment 1.
[Fig. 1-4]
   Fig. 1-4 is a cross-sectional view schematically showing the gate oxide film-forming step in accordance with Embodiment 1.
[Fig. 1-5]
   Fig. 1-5 is a cross-sectional view schematically showing the gate electrode-forming step in accordance with Embodiment 1.
[Fig. 1-6]
   Fig. 1-6 is a cross-sectional view schematically showing the N-type high concentration impurity region-forming step in accordance with Embodiment 1.
[Fig. 1-7]
   Fig. 1-7 is a cross-sectional view schematically showing the interlayer insulating film-forming step in accordance with Embodiment 1.
[Fig. 1-8]
   Fig. 1-8 is a cross-sectional view schematically showing the hydrogen-implanting step in accordance with Embodiment 1.
[Fig. 1-9]
   Fig. 1-9 is a cross-sectional view schematically showing the contact hole-forming step in accordance with Embodiment 1.
[Fig. 1-10]
   Fig. 1-10 is a cross-sectional view schematically showing the titanium layer and titanium nitride layer-forming step in accordance with Embodiment 1.
[Fig. 1-11]
   Fig. 1-11 is a cross-sectional view schematically showing the tetraethoxy silane film-forming step in accordance with Embodiment 1.
[Fig. 2]
   Fig. 2 is a cross-sectional view schematically showing the substrate onto which the single crystal silicon chip is to be transferred in accordance with Embodiment 1.
[Fig. 3-1]
   Fig. 3-1 is a cross-sectional view schematically showing the single crystal silicon chip-transferring step in accordance with Embodiment 1.
[Fig. 3-2]
   Fig. 3-2 is a cross-sectional view schematically showing the bulk silicon-separating step (the step of cleaving the single crystal silicon substrate) in accordance with Embodiment 1.
[Fig. 3-3]
   Fig. 3-3 is a cross-sectional view schematically showing the single crystal silicon substrate-etching step in accordance with Embodiment 1.
[Fig. 3-4]
   Fig. 3-4 is a cross-sectional view schematically showing the titanium silicide-forming step in accordance with Embodiment 1.
[Fig. 3-5]
   Fig. 3-5 is a cross-sectional view schematically showing the interlayer insulating film-forming step, the contact hole-forming step, and the wiring-forming step in accordance with Embodiment 1.

### EXPLANATION OF NUMERALS AND SYMBOLS

- 1:: Single crystal silicon substrate
- 2:: Thermal oxide film
- 4:: P-well region (dotted part)
- 5:: Silicon nitride film
- 6:: LOCOS oxide film
- 7:: Gate oxide film
- 8:: Gate electrode (polysilicon layer)
- 9:: Boron
- 10:: Single crystal silicon layer
- 10s, 10d:: N-type high concentration impurity region
- 10c:: P-type channel region (dotted part)
- 14:: Interlayer insulating film
- 16:: Phosphorus
- 17:: Hydrogen-implanted region (separation layer)
- 19g:: Gate contact hole
- 19s:: Source contact hole
- 19d:: Drain contact hole
- 20g:: Gate wiring
- 20s:: Source electrode wiring
- 20d:: Drain electrode wiring
- 21:: Tetraethoxy silane film
- 24:: Hydrogen ion
- 27:: Titanium silicide layer (shaded part)
- 30:: Titanium layer (the first metal layer)
- 31:: Titanium nitride layer (the second metal layer)
- 40:: Glass substrate
- 41:: Silicon nitride film
- 42:: Silicon oxide film
- 43:: Polysilicon layer
- 43c:: Channel region
- 43d:: Drain region
- 43s:: Source region
- 44:: Gate insulating film
- 45:: Gate electrode
- 53a, 53b, 53c:: Wiring
- 100:: Single crystal silicon chip (semiconductor element)
- 300:: Polysilicon TFT

## Claims

1. A production method of a semiconductor device comprising a semiconductor element on a substrate,
wherein the production method comprises a metal silicide-forming step of:
transferring the semiconductor element onto the substrate,
the semiconductor element having a multilayer structure of a silicon layer and a metal layer, and
by heating, forming metal silicide from silicon for a metal layer-side part of the silicon layer and metal for a silicon layer-side part of the metal layer.

2. The production method of the semiconductor device, according to Claim 1,
wherein the semiconductor element has, as the metal layer, a first metal layer made of a first metal, and a second metal layer made of a second metal different from the first metal, and the metal silicide is formed from silicon for the first metal layer-side of the silicon layer and the first metal for the first metal layer.

3. The production method of the semiconductor device, according to Claim 2,
wherein the first metal layer has a thickness that accounts for 30% or less of a thickness of the silicon layer just before forming the metal silicide.

4. The production method of the semiconductor device, according to Claim 3,
wherein the first metal layer has a thickness that accounts for 20% or less of a thickness of the silicon layer just before forming the metal silicide.

5. The production method of the semiconductor device, according to Claim 2,
wherein the first metal layer is made of at least one metal selected from the group consisting of titanium, molybdenum, tungsten, tantalum, cobalt, nickel, platinum, and rhodium.

6. The production method of the semiconductor device, according to Claim 5,
wherein the first metal layer is made of titanium, and the second metal layer is made of titanium nitride.

7. The production method of the semiconductor device, according to Claim 1,
wherein the substrate is a glass substrate with a strain point of 650°C or more.

8. The production method of the semiconductor device, according to Claim 7,
wherein the metal silicide is formed by heating at 700°C or less.

9. The production method of the semiconductor device, according to Claim 1,
comprising a separation layer-forming step of implanting a hydrogen ion or helium into the silicon layer from a side of the metal layer, thereby forming a separation layer, before the semiconductor element is transferred onto the substrate.

10. The production method of the semiconductor device, according to Claim 9,
comprising a cleavage step of cleaving the silicon layer using the separation layer, before the metal silicide is formed.

11. The production method of the semiconductor device, according to Claim 10,
comprising an etching step of etching the silicon layer that has been cleaved, before the metal silicide is formed.

12. A production method of a display device,
comprising the production method of the semiconductor device according to any one of Claims 1 to 11.

13. A semiconductor device produced using the production method of the semiconductor device according to any one of Claims 1 to 11.

14. A production method of a semiconductor element having a multi-layer structure of a silicon layer and a metal layer,
wherein the production method comprises a metal silicide-forming step of forming metal silicide from silicon for a metal layer-side part of the silicon layer and metal for a silicon layer-side part of the metal layer, by heating.

15. A semiconductor element produced using the productionmethod of the semiconductor element according to Claim 14.
